# EUROPÄISCHE PATENTSCHRIFT

(11) **EP 1 597 823 B1**
(45) Veröffentlichungstag und Bekanntmachung des Hinweises auf die Patenterteilung: **15.11.2006**
(21) Anmeldenummer: 04706764.0
(22) Anmeldetag: 30.01.2004
(51) Int. Cl.: H03F 3/195, H01P 1/22

(54) **INTEGRIERTE VERSTÄRKERANORDNUNG**
INTEGRATED AMPLIFIER ARRANGEMENT
AGENCEMENT D'AMPLIFICATEURS INTEGRES

(30) Priorität: 27.02.2003 DE 10308848
(43) Veröffentlichungstag der Anmeldung: 23.11.2005
(73) Patentinhaber: Marconi Communications GmbH, 71520 Backnang (DE)
(72) Erfinder: GEHARD, Gregor, 71540 Murrhardt (DE); KERN, Stefan, 68753 Waghäusel (DE); KOCH, Stefan, 71570 Oppenweiler (DE)
(74) Vertreter: Cockayne, Gillian
(86) Internationale Anmeldenummer: PCT/IB2004/000744
(87) Internationale Veröffentlichungsnummer: WO 2004/077663

(56) Entgegenhaltungen:
- EP-A- 1 059 727
- US-A- 5 349 312
- WILLEMS D ET AL: "Multifunction chip set for T/R module receive path" IEEE, 7. Mai 1990 (1990-05-07), Seiten 95-98, XP010006380
- WALLACE P W ET AL: "A temperature compensated L-band variable gain amplifier with eight bit digital control" IEEE, 6. November 1988 (1988-11-06), Seiten 281-284, XP010077173
- GRIFFIN E L: "X-band GaAs MMIC size reduction and integration" MICROWAVE SYMPOSIUM DIGEST. 2000 IEEE MTT-S INTERNATIONAL BOSTON, MA, USA 11-16 JUNE 2000, PISCATAWAY, NJ, USA,IEEE, US, 11. Juni 2000 (2000-06-11), Seiten 709-712, XP010507437 ISBN: 0-7803-5687-X
- DEVLIN L M ET AL: "A versatile vector modulator design for MMIC" IEEE, 8. Mai 1990 (1990-05-08), Seiten 519-521, XP010004438
- MILOVANOVIC B ET AL: "A multicarrier amplifier design linearized trough second harmonies and second-order IM feedback" IEEE, Bd. 1, 19. September 2001 (2001-09-19), Seiten 297-300, XP010560940
- GINGRAS R L ET AL: "A quasioptical monolithic monopulse receiver array" 20. April 1993 (1993-04-20), RADAR CONFERENCE, 1993., RECORD OF THE 1993 IEEE NATIONAL LYNNFIELD, MA, USA 20-22 APRIL 1993, NEW YORK, NY, USA,IEEE, US, PAGE(S) 84-87 , XP010067901 ISBN: 0-7803-0934-0 Seite 85, rechte Spalte; Abbildung 4

## Beschreibung

Die vorliegende Erfindung betrifft eine integrierte Verstärkeranordnung für Hochfrequenzsignale im Millimeterwellenbereich.

Monolithisch integrierte Millimeterwellen-Verstärker sind in einstufiger und zweistufiger Form, d.h. in Form von zwei auf einem gemeinsamen Substrat hintereinander geschalteten einstufigen Verstärkern, bekannt, siehe z.B. die Patentanmeldung EP1059727 oder den IEEE-Artikel "Multifunction Chip Set For T/R Module Receive Path", Willems et al, IEEE 1990 Microwave and Millimeter-Wave Monolithic Circuits Symposium. Zweistufige Verstärker werden eingesetzt, wenn eine mit einstufigen Verstärkern nicht ohne Weiteres realisierbare Verstärkung benötigt wird. Sie hat jedoch gegenüber einstufigen Verstärkern den Nachteil, dass der Signalpegelbereich, in dem Verstärkung mit ausreichender Linearität möglich ist, kleiner ist als bei einem einstufigen Verstärker, denn ein Signal, das von einem einstufigen Verstärker oder der ersten Stufe eines zweistufigen Verstärkers mit guter Qualität verstärkt wird, kann leicht einen Pegel erreichen, der zur Sättigung der zweiten Verstärkerstufe führt. Für Anwendungen, bei denen diese Gefahr besteht, werden daher herkömmlicherweise Hybridschaltkreise eingesetzt, die aus einem ersten und einem zweiten Verstärker, jeweils auf einem eigenen Substrat integriert, und zwischen diese eingefügt, einem regelbaren Dämpfer aufgebaut sind, der dazu dient, im Bedarfsfalle den Pegel des Ausgangssignal der ersten Verstärkerstufe so weit zu drosseln, dass eine hinreichend lineare Verstärkung in der zweiten Verstärkerstufe wieder möglich wird.

Derartige Hybridschaltkreise benötigen wegen der großen Zahl von diskreten Komponenten viel Leiterplattenfläche. Außerdem ist ihre Fertigung aufwändig und kostspielig, da Platzieren und Bonden dieser diskreten Komponenten mit hoher Genauigkeit erfolgen muss, um die gewünschten Eigenschaften der fertigen Verstärker reproduzierbar zu erreichen.

Aufgabe der vorliegenden Erfindung ist, eine integrierte Millimeterwellen-Verstärkeranordnung zu schaffen, die es erlaubt, Eingangssignale über einen großen Pegelbereich hinweg mit guter Linearität zu verstärken, und die einfach, preiswert und platzsparend in der Anwendung ist.

Die Aufgabe wird erfindungsgemäß dadurch gelöst, dass bei einer Millimeterwellen-Verstärkeranordnung mit zwei auf einem gemeinsamen Substrat integrierten Verstärkern ein Ausgang des ersten Verstärkers mit einem Eingang des zweiten Verstärkers über einen regelbaren Dämpfer verbunden ist.

Wenn dieser regelbare Dämpfer zusammen mit den Verstärkern auf dem gleichen Substrat integriert ist, so fallen jegliche Probleme der Platzierung der Verstärker und des Dämpfers relativ zueinander weg, da ihre Lage zueinander durch eine zur Fertigung eingesetzte Maske fest und reproduzierbar vorgegeben ist. Wenn der regelbare Dämpfer auf einem anderen Substrat ausgebildet ist als die Verstärker, so reduzieren sich die Probleme bei der Platzierung ebenfalls, da nur noch zwei Substrate relativ zueinander platziert werden müssen und nicht mehr in herkömmlicher Weise drei.

Der regelbare Dämpfer umfasst einen viertorigen Interdigitalkoppler, allgemein auch als Lange-Koppler bezeichnet, der mit den Verstärkern auf dem gleichen Substrat integriert ist und ein mit dem Ausgang des ersten Verstärkers verbundenes erstes Tor und ein mit dem Eingang des zweiten Verstärkers verbundenes zweites Tor aufweist.

Der regelbare Dämpfer umfasst ferner regelbare Widerstände, die mit einem dritten bzw. einem vierten Tor des Lange-Kopplers verbunden sind. Diese regelbaren Widerstände befinden sich auf einem anderen Substrat, so dass unterschiedliche Fertigungstechniken für die Verstärker und für die regelbaren Widerstände eingesetzt werden können.

Die regelbaren Widerstände sind mit dem dritten und dem vierten Tor des Lange-Kopplers über leitende Luftbrücken verbunden.

Als regelbare Widerstände kommen insbesondere PIN-Dioden oder FETs in Frage.

Der Widerstandswert dieser regelbaren Widerstände wird mit Hilfe einer Regelspannung, bei PIN-Dioden einer Gleichspannung in Durchgangsrichtung und bei FETs einer Gate-Source-Spannung, gesteuert. Wenigstens eine Gleichspannungsquelle zum Liefern dieser Regelspannung ist vorzugsweise mit auf dem Substrat der Verstärker integriert. Bei einer solchen Gleichspannungsquelle kann es sich insbesondere um eine Regelschaltung handeln, die das Ausgangssignal des ersten Verstärkers oder das Eingangssignal des zweiten Verstärkers empfängt und den Gleichspannungspegel anhand des Signalpegels dieses empfangenen Signals festlegt.

Vorzugsweise wird in der erfindungsgemäßen Verstärkeranordnung ein Lange-Koppler verwendet, der zwischen allen seinen vier Toren für eine Gleichspannung durchlässig ist. In diesem Fall genügt eine einzige Gleichspannungsquelle, um beide regelbaren Widerstände mit der Regelspannung zu versorgen.

Um den ersten und/oder den zweiten Verstärker von der Regelspannung der Gleichspannungsquelle zu entkoppeln, ist vorzugsweise zwischen dem Ausgang des ersten Verstärkers und/oder dem Eingang des zweiten Verstärkers und dem entsprechenden Tor des Lange-Kopplers jeweils ein Kondensator angeordnet.

Weitere Merkmale und Vorteile der Erfindung ergeben sich aus der nachfolgenden Beschreibung von Ausführungsbeispielen mit Bezug auf die beigefügten Figuren. Es zeigen:
- Fig. 1: schematisch ein Chip-Layout gemäß einem ersten Ausführungsbeispiel der Erfindung;
- Fig. 2: ein Beispiel für ein Chip-Layout gemäß einer zweiten Ausgestaltung der Erfindung; und
- Fig. 3: ein Beispiel für ein Chip-Layout gemäß einer dritten Ausgestaltung der Erfindung.

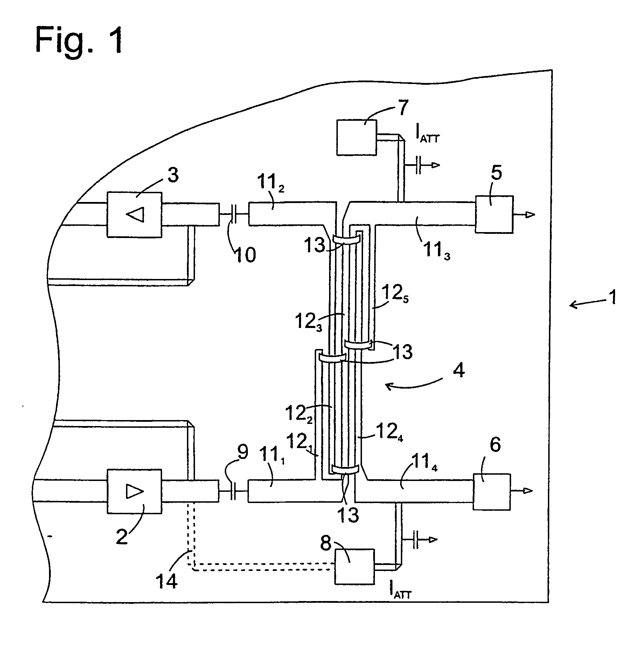

Auf einem in Fig. 1 ausschnittweise dargestellten Halbleitersubstrat 1 sind strukturiert: ein erster Verstärker 2, ein zweiter Verstärker 3, ein Lange-Koppler 4, zwei regelbare Widerstände 5, 6 und zwei Regelschaltungen 7, 8.

Ein Eingang des ersten Verstärkers 2 ist mit einer nicht dargestellten Quelle für ein zu verstärkendes Millimeterwellen-Signal verbunden, welches außerhalb des Halbleitersubstrats 1 liegen kann. Der Ausgang des Verstärkers 2 ist über einen Kondensator 9 an ein erstes Tor 11₁ des Lange-Kopplers angeschlossen. Der Lange-Koppler umfasst fünf parallele Leiterbahnen 12₁, 12₂, ..., 12₅. Die mittlere Leiterbahn 12₃ stellt eine galvanische Verbindung zwischen dem Tor 11₁ und einem diagonal gegenüberliegenden Tor 11₃ her. Sie ist mittig über Luftbrücken 13 mit den übernächst benachbarten, von den Toren 11₁ bzw. 11₃ ausgehenden Leiterbahnen 12₁, 12₅ verbunden. Sich beiderseits der Leiterbahn 12₃ erstreckende Leiterbahnen 12₂, 12₄ gehen jeweils von Toren 11₂ bzw. 11₄ aus und sind an ihren Enden ebenfalls durch Luftbrücken 13 verbunden.

An das zweite Tor 11₂ ist über einen Kondensator 10 der Eingang des zweiten Verstärkers 3 angeschlossen. An die Tore 11₃, 11₄ ist jeweils ein regelbarer Widerstand 5 bzw. 6 und eine ihm zugeordnete Regelschaltung 7 bzw. 8 angeschlossen. Die Regelschaltungen 7, 8 sind identisch aufgebaut und mit einem gleichen Eingangssignal beschaltet. Dieses Eingangssignal kann, wie durch eine gestrichelt eingezeichnete Verbindung 14 angedeutet, vom Ausgang des ersten Verstärkers 2 abgeleitet sein, so dass die Regelschaltungen 7, 8 einen Dämpfungsstrom I_{ATT} an die regelbaren Widerstände 5, 6 liefern, der in Abhängigkeit vom Ausgangspegel des ersten Verstärkers 2 so vorgegeben ist, dass das Eingangssignal des zweiten Verstärkers 3 stets zuverlässig in dessen linearem Bereich liegt.

Die regelbaren Widerstände 5, 6 sind hier als PIN-Dioden realisiert, die jeweils eine mit Masse verbundene Elektrode aufweisen und vom Dämpfungsstrom I_{ATT} in Durchgangsrichtung durchflossen werden. Alternativ wäre auch eine Realisierung in Form von Feldeffekttransistoren möglich, über deren Drain und Source Strom zwischen dem zugeordneten Tor 11₃ oder 11₄ des Lange-Kopplers und Masse fließt und deren Widerstand durch eine von der Regelschaltung 7 bzw. 8 an das Gate des FET angelegte Spannung gesteuert ist.

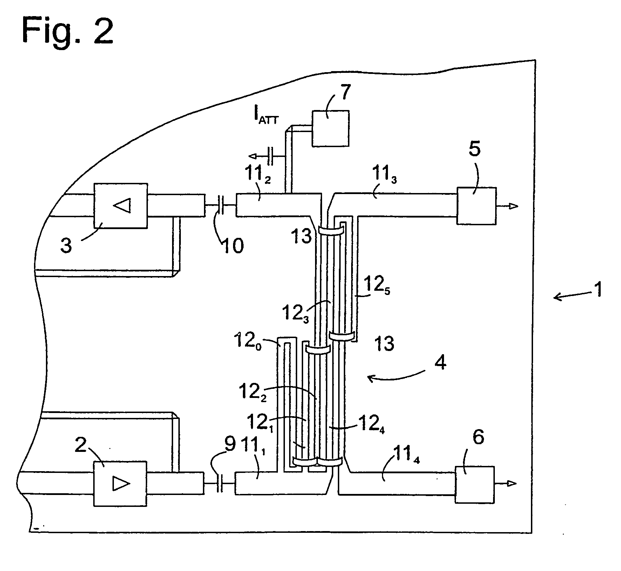

Fig. 2 zeigt eine weiterentwickelte Ausgestaltung der erfindungsgemäßen Verstärkeranordnung. Elemente dieser Anordnung, die bereits mit Bezug auf Fig. 1 beschriebenen Elementen entsprechen, tragen die gleichen Bezugszeichen und werden nicht erneut beschrieben.

Ein Unterschied zwischen dieser Ausgestaltung und der der Fig. 1 ist eine zusätzliche Leiterbahn 12₀ des Lange-Kopplers 4. Die vom Tor 11₁ ausgehende Leiterbahn 12₀ ist doppelt so lang wie die ihr benachbarte Leiterbahn 12₁, ist jedoch auf halber Länge in sich zurückgefaltet, so dass die Spitze der Leiterbahn 12₀ in unmittelbarer Nähe des Tors 11₁ liegt. Diese Spitze ist durch eine weitere Luftbrücke 13 mit der Spitze der vom Tor 11₂ ausgehenden Leiterbahn 12₂ verbunden. Diese zusätzliche Luftbrücke 13 gewährleistet eine galvanische Verbindung zwischen allen vier Toren des Lange-Kopplers 4. Es genügt daher eine einzige Regelschaltung 7, um einen Dämpfungsstrom I_{ATT} zu erzeugen, mit dem beide regelbaren Widerstände 5, 6 versorgt werden. Die Regelschaltung 7 ist hier an das Tor 11₂ angeschlossen, so dass der Regelstrom zu beiden regelbaren Widerständen 5, 6 wenigstens eine der Leiterbahnen des Lange-Kopplers durchfließen muss. Die Leiterbahnen des Lange-Kopplers 4 bilden somit für den Dämpfungsstrom I_{ATT} einen Vorwiderstand in Reihe mit den regelbaren Widerständen 5, 6, der aber, da für beide regelbaren Widerstände 5, 6 im Wesentlichen gleich, zu keiner Asymmetrie im Verhalten der regelbaren Widerstände führt. Eine solche Asymmetrie könnte auftreten, wenn die Regelschaltung 7 unmittelbar an eines der Tore 11₃, 11₄ angeschlossen wäre.

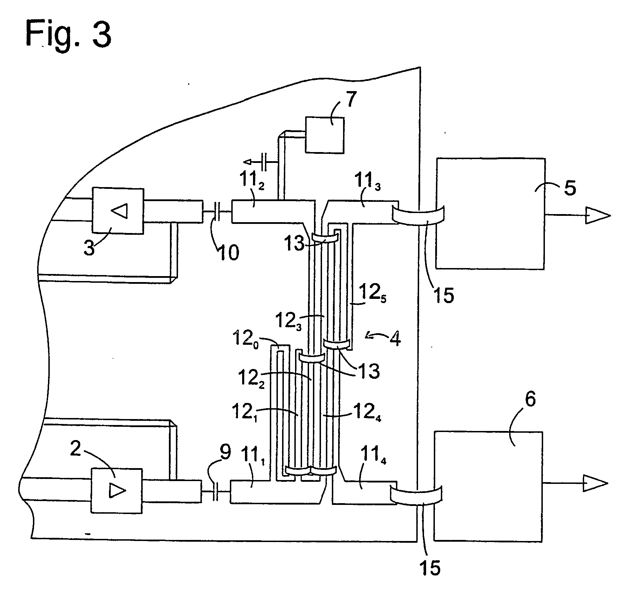

Das Ausführungsbeispiel der Fig. 3 unterscheidet sich von dem der Fig. 2 dadurch, dass die regelbaren Widerstände 6, 7 hier außerhalb des Halbleitersubstrats 1 als separate Bauelemente realisiert und mit den zugeordneten Toren 11₃, 11₄ des Lange-Kopplers 4 über Luftbrücken 15 verbunden sind. Diese Ausgestaltung erlaubt es, für die Herstellung der regelbaren Widerstände andere Fertigungstechnologien einzusetzen als für die Verstärker 2, 3 und den Lange-Koppler 4. Da der Lange-Koppler 4 zusammen mit den Verstärkern 2, 3 auf dem gleichen Substrat 1 integriert ist, können Phasenverschiebungen des zu verstärkenden Signals zwischen den zwei Verstärkern 2, 3 genau kontrolliert werden und sind für alle Verstärker einer Serie einheitlich, da durch die Struktur der verwendeten Masken vorgegeben.

## Patentansprüche

1. Millimeterwellen-Verstärkeranordnung mit zwei auf einem gemeinsamen Substrat (1) integrierten Verstärkern (2, 3), wobei ein Ausgang des ersten Verstärkers (2) mit einem Eingang des zweiten Verstärkers (3) über einen regelbaren Dämpfer (4, 5, 6) verbunden ist,
**dadurch gekennzeichnet, dass** der regelbare Dämpfer einen Lange-Koppler (4) umfasst, von dem ein Tor (11₁) mit dem Ausgang des ersten Verstärkers (2) und weiteres Tor (11₂) mit dem Eingang des zweiten Verstärkers (3) verbunden ist, und dass der Lange-Koppler (4) mit den Verstärkern (2, 3) auf dem gleichen Substrat (1) integriert ist,
wobei der regelbare Dämpfer ferner regelbare Widerstände (5, 6) umfasst, die außerhalb des Substrats (1) angeordnet und mit einem dritten und einem vierten Tor (11₃, 11₄) des Lange-Kopplers (4) über leitende Luftbrücken (15) verbunden sind.

2. Millimeterwellen-Verstärkeranordnung nach Anspruch 1, **dadurch gekennzeichnet, dass** die regelbaren Widerstände (5, 6) durch PIN-Dioden oder FETs gebildet sind.

3. Millimeterwellen-Verstärkeranordnung nach einem der Ansprüche 1 oder 2, **dadurch gekennzeichnet, dass** wenigstens eine Gleichspannungsquelle (7) zum Liefern einer Regelspannung für die regelbaren Widerstände (5, 6) auf dem Substrat (1) integriert ist.

4. Millimeterwellen-Verstärkeranordnung nach Anspruch 3, **dadurch gekennzeichnet, dass** der Lange-Koppler (4) für eine Gleichspannung zwischen allen vier Toren (11₁, 11₂, 11₃, 11₄) durchlässig ist, und dass die genau eine Gleichspannungsquelle (7) beide regelbaren Widerstände (5, 6) versorgt.

5. Millimeterwellen-Verstärkeranordnung nach Anspruch 4, **dadurch gekennzeichnet, dass** der Ausgang des ersten Verstärkers (2) und/oder der Eingang des zweiten Verstärkers (3) mit dem entsprechenden Tor (11₁, 11₂) des Lange-Kopplers (4) über einen Kondensator (9, 10) verbunden ist.

## Claims

1. Millimeter wave amplifier arrangement with two amplifiers (2, 3) integrated on a common substrate (1), in which one output of the first amplifier (2) is connected in an input of the second amplifier (3) via a controllable attenuator (4, 5, 6)
**characterized by** the fact that the controllable attenuator includes a Lange coupler (4), one port (11₁) of which is connected to the output of the first amplifier (2) and an additional port (11₂) is connected to the input of the second amplifier (3), and that the Lange coupler (4) is integrated with the amplifiers (2, 3) on the same substrate (1),
wherein the controllable attenuator also includes controllable resistors (5, 6) arranged outside of substrate (1) and connected to a third and fourth port (11₃, 11₄) of Lange coupler (4) via conducting air bridges (15).

2. Millimeter wave amplifier arrangement according to Claim 1, **characterized by** the fact that the controllable resistors (5, 6) are formed by PIN diodes or FETs.

3. Millimeter wave amplifier arrangement according to one of Claims 1 or 2, **characterized by** the fact that at least one DC source (7) is integrated on substrate (1) to deliver a control voltage for the controllable resistors (5, 6).

4. Millimeter wave amplifier arrangement according to Claim 3, **characterized by** the fact that the Lange coupler (4) is conducting for a dc voltage between all four ports (11₁,11₂,11₃,11₄) and that the voltage source (7) supplies both controllable resistors (5, 6).

5. Millimeter wave amplifier arrangement according to Claim 4, **characterized by** the fact that the output of the first amplifier (2) and/or the input of second amplifiers (3) are connected to the corresponding port (11₁, 11₂) of Lange coupler (4) via a capacitor (9, 10).

## Revendications

1. Dispositif amplificateur d'onde millimétrique comportant deux amplificateurs (2,3) intégrés sur un substrat commun (1), dans lequel une sortie du premier amplificateur (2) est connectée à une entrée du second amplificateur (3) via un atténuateur commandable (4, 5, 6)
**caractérisé en ce que** l'atténuateur commandable inclut un coupleur de Lange (4), dont un port (11₁) est connecté à la sortie du premier amplificateur (2) et un port additionnel (11₂)est connecté à l'entrée du second amplificateur (3) et **en ce que** le coupleur de Lange (4) est intégré aux amplificateurs (2,3) sur le même substrat (1).

2. Dispositif amplificateur d'onde millimétrique selon la revendication 1, **caractérisé en ce que** les résistances commandables (5,6) sont formées par des diodes PIN ou des FETs.

3. Dispositif amplificateur d'onde millimétrique selon une des revendications 1 ou 2, **caractérisé en ce que** au moins une source de courant continu (7) est intégrée au substrat (1) afin de délivrer une tension de commande aux résistances commandables (5,6).

4. Dispositif amplificateur d'onde millimétrique selon la revendication 3, **caractérisé en ce que** le coupleur de Lange (4) est conducteur pour une tension directe entre tous les quatre ports (11₁, 11₂, 11₃, 11₄) et **en ce que** la source de tension (7) alimente les deux résistances commandables (5,6).

5. Dispositif amplificateur d'onde millimétrique selon la revendication 4, **caractérisé en ce que** la sortie du premier amplificateur (2) et/ou l'entrée du second amplificateur (3) sont connectées au port correspondant (11₁, 11₂) du coupleur de Lange (4) via un condensateur (9,10).
